# EUROPEAN PATENT APPLICATION

(11) **EP 4 790 906 A1**
(43) Date of publication of application: **12.08.2026**
(21) Application number: 25842868.9
(22) Date of filing: 20.05.2025
(51) Int. Cl.: H03M 13/27, H03M 13/15, H03M 13/09

(54) **DATA PROCESSING METHODS, DATA PROCESSING APPARATUSES AND DATA TRANSMISSION SYSTEM**

(30) Priority: 09.12.2024 CN 202411806114
(71) Applicant: Hygon Information Technology Co., Ltd., Binhai New Area, Tianjin 300392 (CN)
(72) Inventor: WANG, Yuxuan, Tianjin 300392 (CN); ZHOU, Peng, Tianjin 300392 (CN); LI, Yanjie, Tianjin 300392 (CN)
(74) Representative: Maiwald GmbH
(86) International application number: PCT/CN2025/096013
(87) International publication number: WO 2026/123594

(57) **Abstract**

At least one embodiment of the present disclosure provides a data processing method, a data processing apparatus, and a data transmission system. The data processing method includes: performing an encoding operation based on original data to generate N independent error correction codewords, where each error correction codeword of the N independent error correction codewords comprises a data code and a check code, and N is an integer and N ≥ 2; interleaving data codes and check codes comprised in the N independent error correction codewords to obtain interleaved data; and transmitting the interleaved data. The data processing method can effectively reduce the complexity of encoding/decoding and error correction, reduce the time for corresponding encoding/decoding and error correction, and reduce data transmission delay.

## Description

### CROSS-REFERENCE TO RELATED APPLICATION

The present application claims the priority to Chinese Patent Application No. 202411806114.5, filed on December 9, 2024, the entire disclosure of which is incorporated herein by reference as portion of the present application.

### TECHNICAL FIELD

Embodiments of the present disclosure relate to a data processing method, a data processing apparatus, and a data transmission system.

### BACKGROUND

In modern communication systems, the reliability of data transmission is crucial to ensure the integrity of information. However, during the process of data transmission, channel noise and interference often cause errors. To address this issue, error correction code technology is widely used in data transmission.

### SUMMARY

At least one embodiment of the present disclosure provides a data processing method including: performing an encoding operation based on original data to generate N independent error correction codewords, where each error correction codeword of the N independent error correction codewords includes a data code and a check code, and N is an integer and N ≥ 2; interleaving data codes and check codes included in the N independent error correction codewords to obtain interleaved data; and transmitting the interleaved data.

At least one embodiment of the present disclosure provides a data processing method including: receiving interleaved data to obtain read-back data codes and read-back error correction codes, where the interleaved data is obtained by performing an encoding operation based on original data to generate N independent error correction codewords, and interleaving data codes and check codes included in the N independent error correction codewords, each error correction codeword of the N independent error correction codewords includes a data code and a check code, and N is an integer and N ≥ 2; deinterleaving the read-back data codes and the read-back error correction codes to obtain N independent read-back error correction codewords; and performing decoding and error correction operations on the N independent read-back error correction codewords.

At least one embodiment of the present disclosure provides a data processing apparatus including: an error correction codeword generation unit, configured to perform an encoding operation based on original data to generate N independent error correction codewords, where each error correction codeword of the N independent error correction codewords includes a data code and a check code, and N is an integer and N ≥ 2; an interleaving unit, configured to interleave data codes and check codes included in the N independent error correction codewords to obtain interleaved data; and a transmitting unit, configured to transmit the interleaved data to a data receiving end.

At least one embodiment of the present disclosure provides a data processing apparatus including: a receiving unit, configured to receive interleaved data to obtain read-back data codes and read-back error correction codes, where the interleaved data is obtained by performing an encoding operation on original data to generate N independent error correction codewords, and interleaving the data codes and check codes included in the N independent error correction codewords, each error correction codeword of the N independent error correction codewords includes a data code and a check code, and N is an integer and N ≥ 2; a deinterleaving unit, configured to deinterleave the read-back data codes and the read-back error correction codes to obtain N independent read-back error correction codewords; and a decoding and error correction unit, configured to perform decoding and error correction operations on the N independent read-back error correction codewords.

At least one embodiment of the present disclosure provides a data transmission system including the data processing apparatus mentioned above;

At least one embodiment of the present disclosure provides an electronic apparatus including: at least one processor; and at least one memory storing instructions, where the instructions, when executed by a processor, cause the processor to perform the data processing method mentioned above;

At least one embodiment of the present disclosure provides a computer-readable storage medium storing computer-readable instructions, where the computer-readable instructions, when executed by a processor, cause the processor to perform the data processing method mentioned above.

### BRIEF DESCRIPTION OF DRAWINGS

In order to clearly illustrate the technical solutions of the embodiments of the present disclosure, the drawings of the embodiments will be briefly described in the following; it is obvious that the described drawings are only related to some embodiments of the present disclosure and thus are not limitative of the present disclosure.
Fig. 1 shows a schematic diagram of an exemplary end-to-end serial link system;
Fig. 2 shows a flowchart of a data processing method according to at least one embodiment of the present disclosure;
Fig. 3 shows a flowchart of a data processing method according to at least one embodiment of the present disclosure;
Fig. 4 shows a schematic diagram of a data processing apparatus according to at least one embodiment of the present disclosure;
Fig. 5 shows a schematic diagram of a data processing apparatus according to at least one embodiment of the present disclosure;
Fig. 6 shows a schematic diagram of a data transmission system according to at least one embodiment of the present disclosure;
Fig. 7 shows a schematic diagram of a decoding and error correction process according to at least one embodiment of the present disclosure;
Fig. 8 shows a block diagram of syndrome calculation according to at least one embodiment of the present disclosure;
Fig. 9 shows a block diagram of a key equation according to at least one embodiment of the present disclosure;
Fig. 10 shows a schematic diagram of a Chien search circuit according to at least one embodiment of the present disclosure;
Fig. 11 shows a schematic diagram of a four-way interleaved structure according to at least one embodiment of the present disclosure;
Fig. 12 shows a schematic diagram of a four-way deinterleaved structure according to at least one embodiment of the present disclosure;
Fig. 13 shows a structural diagram of four-way interleaved data according to at least one embodiment of the present disclosure;
Fig. 14 shows a schematic diagram of an electronic apparatus according to at least one embodiment of the present disclosure;
Fig. 15 shows a schematic diagram of a computer-readable storage medium according to at least one embodiment of the present disclosure; and
Fig. 16 shows a schematic diagram of another electronic apparatus according to at least one embodiment of the present disclosure.

### DETAILED DESCRIPTION

Embodiments of the present disclosure are exemplified in the drawings, and reference will be made in detail to the embodiments of the present disclosure. Although the present disclosure will be described in connection with the embodiments, it should be understood that it is not intended to limit the present disclosure to the described embodiments. Rather, it is intended to cover changes, modifications, and equivalents included within the spirit and scope of the present disclosure as defined by the appended claims. It should be noted that the method operations described herein may be implemented by any functional block or functional arrangement, and that any functional block or functional arrangement may be implemented as a physical entity or a logical entity, or a combination of both.

In order to provide those skilled in the art with a better understanding of the present disclosure, it is described in further detail below in connection with the drawings and the embodiments.

It should be noted that examples to be introduced next are only specific examples and are not intended to limit specific appearance, hardware, connection relationships, operations, numerical values, conditions, data, sequence, etc. that must be shown and described in the embodiments of the present disclosure. Those skilled in the art may construct more embodiments not mentioned in this specification by using the concepts of the present disclosure through reading this specification.

The terms used in the present disclosure are those commonly used terms in the field at present in consideration of the functionality of the present disclosure, but these terms may vary according to intentions, precedents, or new technologies in the field of those ordinarily skilled in the art. In addition, specific terms may be chosen by the applicant, and in such cases, detailed meanings thereof will be described in the detailed description of the present disclosure. Therefore, the terms used in the specification should not be understood as simple names, but rather based on the meaning of the terms and the overall description of the present disclosure.

A flowchart is used in the present disclosure to illustrate operations executed by the system according to the embodiments of the present disclosure. It should be understood that the preceding or following operations may not be executed precisely in order. On the contrary, various steps may be processed in reverse order or simultaneously as needed. Meanwhile, other operations may also be added to these processes, or a certain step or several steps may be removed from these processes.

Firstly, abbreviations and related terms involved in the present disclosure will be defined and illustrated.

Error Correction Code (ECC): error correction code or error correction coding, referring to a coding technology capable of error checking and correction, which may improve the reliability of system.

Correctable Error (CE): an error that is correctable.

Uncorrectable Error (UE): an error that is uncorrectable.

Symbol: also referred to as a code element, which is the smallest unit in ECC error correction. Generally, x4 and x8 memory chips are used, where the corresponding symbols may be 4-bit data and 8-bit data respectively.

Serializer/Deserializer (SERDES): a digital communication interface technology, used to convert parallel data into serial data, and convert serial data into parallel data. It plays an important role in high-speed communication systems.

Forward Error Correction (FEC) technology: a method for detecting and correcting errors in data transmission. It uses redundant bits to store check information during data encoding, and when errors occur during data transmission, the error location may be determined and corrected through the check information.

Link equalization: a technology used to eliminate distortion and noise in signal transmission.

Reed-Solomon(RS) coding algorithm: an error correct coding algorithm, which is a on-binary block code commonly used for error correction in data transmission and storage. The basic principle is to encode original data at a transmitting end to generate a certain amount of redundant data, which is transmitted together with the original data. After receiving the data, a receiving end uses the redundant data to perform error decoding and correction. If correctable errors occur to the data, the receiving end may use the information in the redundant data for correction without retransmitting the data.

Interleaving: bit errors in communication often occur in bursts, but channel coding is only effective in detecting and correcting single error or error bursts of not too long length. When the length of a burst error exceeds the error correction capability of FEC, FEC cannot effectively reduce the bit error rate and packet loss rate. Interleaving is a technology used to reduce the impact of burst errors on the system. It enhances data reliability by dividing original data into four independent data streams, and alternately arranging these data streams into a new data stream. In this way, long burst errors are scattered into several short burst errors, which are then corrected by several FECs respectively, thereby improving system performance.

Bit Error Rate (BER): an indicator used to evaluate the bit transmission error rate in digital communication systems, which represents the proportion of bits that are in error among the bits received by the receiving end during the digital signal transmission process.

Feed forward equalizer (FFE): the feed forward equalizer may be categorized into Pre-Emphasis and De-Emphasis, both of which employ similar methods, which change the high and low frequency components at the transmitting (TX) end, where the difference is that the Pre-Emphasis increases high-frequency components, while De-Emphasis reduces low-frequency components. After the equalization at the TX end, signal quality may be improved.

Continuous time linear equalizer (CTLE): an amplifier circuit with a frequency response curve, which amplifies high-frequency signals and attenuates low-frequency signals, thereby compensating the insertion loss of the channel.

Decision Feedback Equalizer (DFE): a digital signal processing technology used to recover digital signals affected by channel interference and distorted. In a circuit, the DFE is generally after CTLE. The implementation of DFE is similar to that of FFE.

Packet loss rate: indicate the probability of that errors exceed the error correction capability of FEC, and the entire packet may only be discarded. After being discarded, the receiving end will request retransmission.

It may be understood that the terms defined above are only exemplary definitions in specific application scenarios for better understanding of the present disclosure, and the embodiments of the present disclosure are not limited thereto.

As the signal rate increases, signal quality deteriorates in two aspects. On the one hand, due to the shorter clock cycle, the impact of inherent jitter becomes serious. On the other hand, the increased rate makes the channel loss larger, and inter-symbol interference becomes more serious. Generally, high-frequency signal compensation and equalization technologies may be used to alleviate this weakness.

The role of equalization is to process the signal at the receiving port, and appropriately enhance, according to the attenuation characteristics of the substrate through which the signal passes, the high-frequency components of the signal, so that a signal in which the low-frequency components and high-frequency components are "equalized" to the same level may be obtained, thereby enhances the transmission speed and transmission distance of the signal transmitted to the receiving port.

Equalization may be categorized into transmitting end equalization and receiving end equalization. Transmitting end equalization is called Emphasis or FFE.

Receiving end equalization includes both CTLE and DFE. DFE can assist CTLE in improving signal quality. In addition, DFE can perform adaptive adjustment in real-time according to the condition of the eye diagram, which may be used to compensate for changes in links and chips (such as CTLE) caused by temperature or other condition variations, thereby increasing system stability.

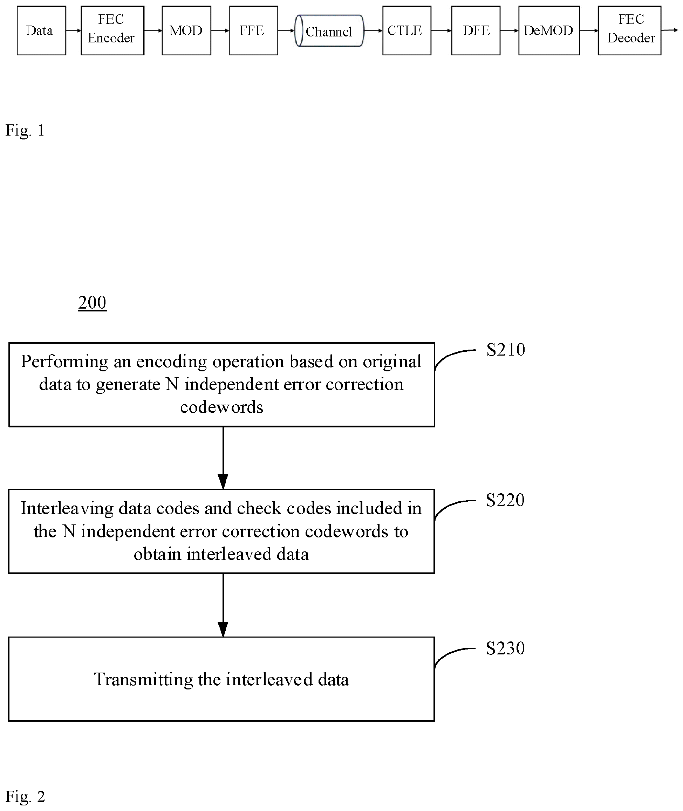

Fig. 1 shows a schematic diagram of an exemplary end-to-end serial link system.

Referring to Fig. 1, at the data transmitting end, data may be encoded by an FEC encoder to generate encoded data. The encoded data may be converted from digital signal into analog signal through modulation (MOD). The analog signals may have their high and low frequency components altered through FFE, and may subsequently be transmitted through a channel.

At the data receiving end, the received analog signal may be improved through CTLE and DFE, and then may be converted from the analog signal back to a digital signal through demodulation (DeMOD), and the digital signal is decoded by an FEC decoder to obtain original data.

In actual use, the eye diagram after equalization by CTLE and DFE requires the cooperation of FFE, CTLE, and DFE, especially in cases where the link conditions are relatively complex. In this case, relying solely on FFE, CTLE, or DFE may no longer achieve the opening of the eye diagram, and instead, the cooperation of FFE, CTLE, and DFE is needed to be used, so that the eye diagram at the sampling point of the receiving end may be fully opened, ensuring meeting the target bit error rate.

Exemplary FEC algorithms in high-speed protocol transmission include RS (544, 514) algorithm, which may use 514 10-bit data symbols and 30 10-bit ECC symbols to correct errors in any 15 10-bit symbols. The error correction process is extremely complex, because to find the positions of 15 error symbols, it is necessary to iteratively solve equations 15 times, thereby requiring more area (such as the area of the circuit for corresponding solving) and delay, but with stronger error correction capability.

Another FEC algorithm is RS (272, 258) algorithm, which may use 258 10-bit data symbols and 14 10-bit ECC symbols to correct errors in any 7 symbols. Compared with RS (544, 514) algorithm, the encoding and error correction involved in RS (272, 258) algorithm are simpler, where the error correction module only needs to solve equations 7 times, thus requiring fewer computing resources. RS (272, 258) algorithm, due to its algorithmic simplicity and faster processing speed, is particularly suitable for processing small-scale data blocks, but exhibits slightly weaker error correction capability.

Currently, the market demand for high-speed information transmission is becoming stronger. The higher the data transmission rate is, the greater the challenge to the signal integrity of serial links. To ensure the low cost of the overall link, the channel material is usually not changed, but improvements and research are carried out from the perspective of link architecture, which poses severe challenges to the equalization technology and FEC of ultra-high-speed serial links.

The inventors of the present disclosure have realized that although the traditional RS (544, 514) has large delay, it also has advantages of high code rate and strong capability in correcting random errors. However, at the same time, higher requirements for the modulation of link equalization are also put forward, where the link equalizer, on the one hand, needs to ensure that the bit error rate (BER) is lower than the basic requirement of the protocol for BER; on the other hand, the equalization capability of the equalizer cannot be too strong, where excessively strong equalization capability may instead lead to an increase of the system retransmission rate, and a decrease of bandwidth efficiency. This is because excessively strong equalization capability may bring stronger DFE coefficients, and the DFE, as a nonlinear equalizer, may decide the level of the current signal based on past decision results. If the DFE coefficient is too large, that is, the weight given to past signal is too large, which may give an incorrect decision on the current signal, and errors in the current signal may also affect the next signal, thereby errors may propagate continuously. RS (544, 514), as the FEC specified in the Ethernet protocol, was originally designed for random errors. If errors are continuous, on the one hand, the upper limit of error correction capability (i.e., 5 10-bit symbols) is easily occupied by continuous errors caused by a large number of DFE erroneous decisions; on the other hand, the complex algorithm of RS (544, 514) is useless because errors are most likely to occur in the next symbol, so the ability to correct "arbitrary" (random) errors is not that necessary.

In addition, although RS (272, 258), because its ability to correct random errors is worse than that of RS (544, 514), cannot handle environments with equally poor BER well, but the link may use stronger equalization capability to reduce the BER input to FEC, thus reducing the number of random errors. However, the cost is that the DFE coefficient becomes larger, and a random error may cause an error decision of DFE, resulting in a series of continuous errors caused by DFE following the random error. However, such continuous errors may be well handled by the interleaved structure of RS (272, 258), thereby RS (272, 258) is more suitable for high-speed links.

In addition, when modulating the equalization capability of a link, the final FEC module of the link is generally rarely considered. The FEC is always turned on after determining the FFE coefficient at the TX end (that is, determining the FFE coefficient only based on an eye diagram), which may lead to a reduction of the system performance. This is because for the entire system, the eye diagram is not the larger the better, there is an "optimal point", and once the equalization capability of the link exceeds this optimal point, the retransmission rate of the link may increase instead, and the system performance may decrease. Therefore, the training of the link should consider the FEC capability comprehensively. To exert the optimal performance of RS (544, 514), the FFE coefficient at the TX end of the link is required to be reduced, while due to the lack of joint modeling of equalization and FEC, it is difficult to find the optimal FFE coefficient for the link, which puts forward higher requirements for modulation technology.

It may be seen from the above that future high-speed links need to deal with increasingly large line losses, and the combined use of equalization technology and FEC technology may be a huge challenge.

Therefore, at least one embodiment of the present disclosure proposes a low-latency interleaved error correction structure, which takes both random errors and burst errors into account, and is also friendly to link training. For example, at least one embodiment of the present disclosure proposes a low-latency RS (272, 258) multi-way interleaved error correction structure, where the reason for selecting RS (272, 258) is that it may be well compatible with the encoding and packet grouping methods of original RS (544, 514). Of course, the embodiments of the present disclosure are not limited thereto, and other algorithms may be used.

At least one embodiment of the present disclosure provides a data processing method, a data processing apparatus, a data transmission system, an electronic apparatus and a computer-readable storage medium, which may effectively reduce the complexity of encoding, decoding and error correction, reduce the time for corresponding encoding, decoding and error correction, and reduce data transmission delay.

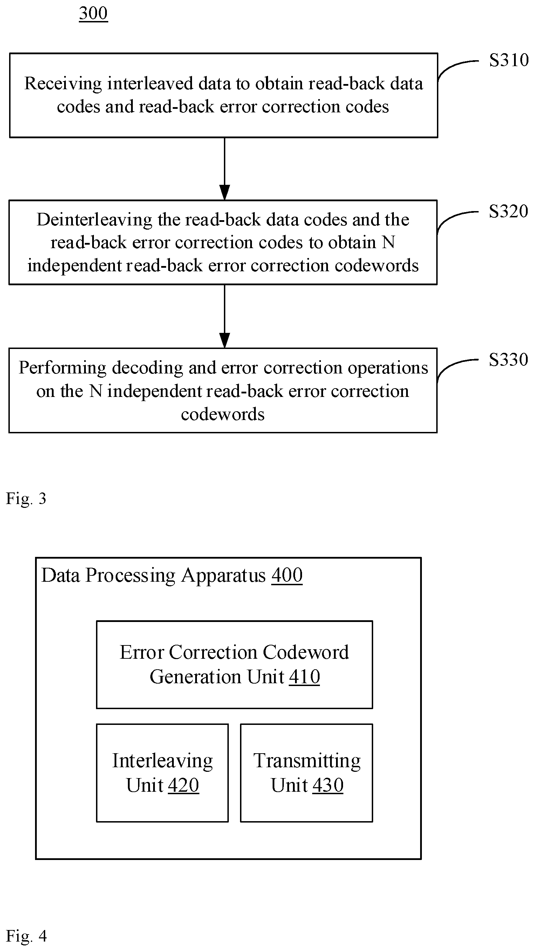

Fig. 2 shows a flowchart of a data processing method 200 according to at least one embodiment of the present disclosure. The data processing method 200 described with reference to Fig. 2 and additional aspects thereof may be implemented in the data processing apparatus 400, an electronic apparatus, a hardware structure, a software structure, or a combination of hardware and software structures described below with reference to Fig. 4. In some embodiments, the data processing method 200 may be performed at a data transmitting end (e.g., a data transmitting apparatus).

Referring to Fig. 2, the data processing method 200 includes steps S210 to S230.

Step S210, performing an encoding operation based on original data to generate N independent error correction codewords, where each error correction codeword of the N independent error correction codewords includes a data code and a check code, and N is an integer and N ≥ 2.

The original data may be any data to be transmitted from the transmitting end to the receiving end.

Step S220, interleaving data codes and check codes included in the N independent error correction codewords to obtain interleaved data.

Step S230, transmitting the interleaved data.

As described above, according to the data processing method 200 according to at least one embodiment of the present disclosure, a plurality of independent error correction codewords of the original data are obtained. Each independent error correction codeword may be interleaved and transmitted, thereby enabling decoding and error correction operations for each independent error correction codeword, which effectively reducing the complexity of encoding, decoding and error correction, reducing the time for corresponding encoding, decoding and error correction, and reducing data transmission delay.

Some exemplary additional aspects of the data processing method 200 according to at least one embodiment of the present disclosure are described below.

For example, according to the data processing method provided by at least one embodiment of the present disclosure, N independent error correction codewords may be transmitted through a plurality of data lanes, and interleaving the data codes and check codes included in the N independent error correction codewords may include: alternately arranging the N independent error correction codewords into a new data stream, so that consecutive M symbols on each data lane of the plurality of data lanes belong to different error correction codewords of the N independent error correction codewords, respectively, where M is an integer and 2 ≤ M ≤ N.

In some examples, M = 2 and N = 4, so that consecutive 2 symbols on each data lane belong to different error correction codewords of the 4 independent error correction codewords, respectively. Of course, the embodiments of the present disclosure are not limited thereto, and M and N may also be other values.

In this way, the data processing method according to at least one embodiment of the present disclosure can avoid consecutive symbols on each data lane coming from the same error correction codeword, thereby effectively preventing exceeding the upper limit of the error correction capability of the corresponding algorithm due to continuous errors, for example, effectively dealing with burst errors on the same data lane.

For example, according to the data processing method provided by at least one embodiment of the present disclosure, M = N.

In some examples, M = 4 and N = 4, so that consecutive 4 symbols on each data lane belong to different error correction codewords of 4 independent error correction codewords, respectively. Of course, the embodiments of the present disclosure are not limited thereto, and M and N may also be other values.

In this way, the data processing method according to at least one embodiment of the present disclosure can further space out respective symbols on each data lane, thereby more effectively preventing exceeding the upper limit of the error correction capability of the corresponding algorithm due to continuous errors, for example, can better deal with burst errors on the same data lane.

For example, the data processing method according to at least one embodiment of the present disclosure may further include: alternately arranging N independent error correction codewords into a new data stream, so that corresponding symbols on adjacent data lanes of the plurality of data lanes belong to different error correction codewords of the N independent error correction codewords.

In this way, the data processing method according to at least one embodiment of the present disclosure can avoid crosstalk on adjacent data lanes.

For example, according to the data processing method of at least one embodiment of the present disclosure, performing an encoding operation based on the original data to generate N independent error correction codewords may include: dividing the original data into N pieces of independent sub-data to serve as data codes; and independently performing the encoding operation on the N pieces of independent sub-data, to obtain error correction codes for each of the N pieces of independent sub-data to serve as check codes.

In this way, the data processing method according to at least one embodiment of the present disclosure can independently generate a plurality of error correction codewords for original data, thereby improving the efficiency of generating error correction codewords and reducing the complexity of the algorithm used to generate error correction codewords.

For example, according to the data processing method provided by at least one embodiment of the present disclosure, dividing original data into N pieces of independent sub-data may include: randomly dividing the original data into N pieces of independent sub-data.

In this way, compared with fixedly dividing original data into N pieces of independent sub-data, the data processing method according to at least one embodiment of the present disclosure can improve the error correction capability at the probability level, and can be applied to more general error scenarios.

For example, original 256B data is fixedly divided into high 128B and low 128B as 2 pieces of independent sub-data, and the error correction probability of correcting 2 errors in each of these 2 pieces of sub-data is $2 ∗ {C}_{n}^{2} = 2 ∗ \left(n-1\right) ∗ \left(n-2\right) / \left(2∗1\right)$. In contrast, the present disclosure randomly divides the original 256B data into 4 pieces of 64B sub-data (instead of fixed high 128B and low 128B), and the error correction probability of correcting 2 errors in each of the 4 pieces of sub-data is ${C}_{n}^{4} = n ∗ \left(n-1\right) ∗ \left(n-2\right) ∗ \left(n-3\right) / \left(4∗3∗2∗1\right)$. Here, n is the number of symbols. In some examples, one symbol may be 1B (8 bits) or other numbers of bits.

For another example, in practical applications, because errors may occur randomly, in the above example, fixed division has situations where a plurality of errors appear in, for example, high 128B, thereby cannot be corrected. In contrast, the data processing method according to at least one embodiment of the present disclosure is relatively flexible, and thus may be applied to more general application scenarios.

For example, according to the data processing method provided by at least one embodiment of the present disclosure, randomly dividing original data into N pieces of independent sub-data may include: randomly dividing the original data into N pieces of independent sub-data with equal size.

In this way, according to the data processing method provided by at least one embodiment of the present disclosure, the same N encoding and/or decoding and error correction methods may be used, which simplifies the design of the corresponding data transmission system.

For example, according to the data processing method of at least one embodiment of the present disclosure, N = 4.

In this way, the data processing method according to at least one embodiment of the present disclosure may employ four-way interleaving, thereby dealing with various application scenarios.

For example, according to the data processing method provided by at least one embodiment of the present disclosure, the encoding operation may employ RS (272, 258) algorithm.

In this way, compared with RS (544, 514) algorithm, the data processing method according to at least one embodiment of the present disclosure can reduce delay and/or improve code rate.

For example, compared with RS (544, 514) algorithm, the encoding operation and/or subsequent decoding and error correction operations employing RS (272, 258) algorithm have fewer iteration times, which may reduce delay.

For another example, compared with RS (544, 514) algorithm, which may have 5140 bits of data in every 5440 bits, RS (272, 258) algorithm may have 5160 bits of data in every 5440 bits, thus having a higher code rate.

For example, according to the data processing method provided by at least one embodiment of the present disclosure, the interleaved data may be transmitted through a high-speed link, and the high-speed link supports the interleaved data to be transmitted in the form of at least one of an electrical signal and an optical signal.

In this way, the data processing method according to at least one embodiment of the present disclosure can be applied to transmitting and receiving data through electrical signal, transmitting and receiving data through optical signal, or transmitting and receiving data through both electrical and optical signal.

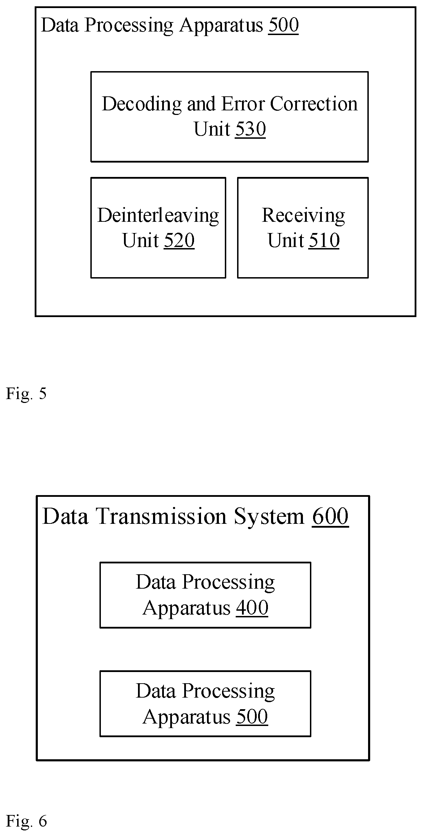

Fig. 3 shows a flowchart of a data processing method 300 according to at least one embodiment of the present disclosure. The data processing method 300 described with reference to Fig. 3 and additional aspects thereof may be implemented in the data processing apparatus 500, an electronic apparatus, a hardware structure, a software structure, or a combination of hardware structure and software structures described below with reference to Fig. 5. In some embodiments, the data processing method 300 may be performed at a data receiving end (e.g., a data receiving apparatus).

Referring to Fig. 3, the data processing method 300 includes steps S310 to S330.

Step S310, receiving interleaved data to obtain read-back data codes and read-back error correction codes. The interleaved data is obtained by performing an encoding operation on original data to generate N independent error correction codewords, and interleaving data codes and check codes included in the N independent error correction codewords. Each error correction codeword of the N independent error correction codewords includes a data code and a check code, where N is an integer and N ≥ 2.

Step S320, deinterleaving the read-back data codes and the read-back error correction codes to obtain N independent read-back error correction codewords.

Step S330, performing decoding and error correction operations on the N independent read-back error correction codewords.

As described above, the data processing method 300 according to at least one embodiment of the present disclosure can deinterleave, for example, the interleaved data described with reference to Fig. 2, to obtain independent read-back error correction codewords, and can perform decoding and error correction operations on the independent read-back error correction codewords, thereby enabling decoding and error correction operations for each independent error correction codeword, which effectively reducing the complexity of encoding, decoding and error correction, reducing the time for corresponding encoding, decoding and error correction, and reducing data transmission delay.

Some exemplary additional aspects of the data processing method 300 according to at least one embodiment of the present disclosure are described below.

For example, according to the data processing method provided by at least one embodiment of the present disclosure, performing decoding and error correction operations on N independent read-back error correction codewords may include: independently performing decoding and error correction operations on each read-back error correction codeword of the N independent read-back error correction codewords.

In this way, the data processing method according to at least one embodiment of the present disclosure can independently perform decoding and error correction operations on each independent read-back error correction codeword, which improves the efficiency of decoding and error correction, and reducing the complexity of the algorithm used for decoding and error correction.

In other additional aspects, the data processing method 200 described with reference to Fig. 2 and its additional aspects may also be applied to the data processing method 300 described with reference to Fig. 3, and the corresponding technical effects may also be mapped to the additional aspects of the data processing method 300 described with reference to Fig. 3, which will not be repeated here.

Corresponding to the data processing method 200 according to at least one embodiment of the present disclosure, at least one embodiment of the present disclosure further provides a data processing apparatus. For example, the data processing apparatus may be a data transmitting apparatus.

Fig. 4 shows a schematic diagram of a data processing apparatus 400 according to at least one embodiment of the present disclosure.

Referring to Fig. 4, the data processing apparatus 400 includes an error correction codeword generation unit 410, an interleaving unit 420, and a transmitting unit 430.

The error correction codeword generation unit 410 is configured to perform an encoding operation based on original data to generate N independent error correction codewords, where each error correction codeword of the N independent error correction codewords includes a data code and a check code, and N is an integer and N ≥ 2;

The interleaving unit 420 is configured to interleave the data codes and the check codes included in the N independent error correction codewords to obtain interleaved data.

The transmitting unit 430 is configured to transmit the interleaved data to a data receiving end.

As described above, the data processing apparatus 400 according to at least one embodiment of the present disclosure can obtain a plurality of independent error correction codewords of the original data. Each independent error correction codeword can be interleaved and transmitted, thereby enabling decoding and error correction operations for each independent error correction codeword, which effectively reducing the complexity of encoding, decoding and error correction, reducing the time for corresponding encoding, decoding and error correction, and reducing data transmission delay.

The additional aspects of the data processing apparatus 400 according to at least one embodiment of the present disclosure may correspond to the additional aspects of the data processing method 200 according to at least one embodiment of the present disclosure. Therefore, the technical effects of the additional aspects of the data processing method 200 according to at least one embodiment of the present disclosure may also be mapped to the additional aspects of the data processing apparatus 400 according to at least one embodiment of the present disclosure, which will not be repeated here.

Corresponding to the data processing method 300 according to at least one embodiment of the present disclosure, at least one embodiment of the present disclosure further provides a data processing apparatus. For example, the data processing apparatus may be a data receiving apparatus.

Fig. 5 shows a schematic diagram of a data processing apparatus 500 according to at least one embodiment of the present disclosure.

Referring to Fig. 5, the data processing apparatus 500 includes a receiving unit 510, a deinterleaving unit 520, and a decoding and error correction unit 530.

The receiving unit 510 is configured to receive interleaved data to obtain read-back data codes and read-back error correction codes, where the interleaved data is obtained by performing an encoding operation on original data to generate N independent error correction codewords, and interleaving the data codes and check codes included in the N independent error correction codewords. Each error correction codeword of the N independent error correction codewords includes a data code and a check code, where N is an integer and N ≥ 2.

The deinterleaving unit 520 is configured to deinterleave the read-back data codes and the read-back error correction codes to obtain N independent read-back error correction codewords.

The decoding and error correction unit 530 is configured to perform decoding and error correction operations on the N independent read-back error correction codewords.

As described above, the data processing apparatus 500 according to at least one embodiment of the present disclosure can deinterleave, for example, the interleaved data described with reference to Fig. 2, to obtain independent read-back error correction codewords, and can perform decoding and error correction operations on the independent read-back error correction codewords, thereby enabling decoding and error correction operations for each independent error correction codeword, which effectively reducing the complexity of encoding, decoding and error correction, reducing the time for corresponding encoding, decoding and error correction, and reducing data transmission delay.

The additional aspects of the data processing apparatus 500 according to at least one embodiment of the present disclosure may correspond to the additional aspects of the data processing method 300 according to at least one embodiment of the present disclosure. Therefore, the technical effects of the additional aspects of the data processing method 300 according to at least one embodiment of the present disclosure may also be mapped to the additional aspects of the data processing apparatus 500 according to at least one embodiment of the present disclosure, which will not be repeated here.

Fig. 6 shows a schematic diagram of a data transmission system 600 according to at least one embodiment of the present disclosure. As shown in Fig. 6, the data transmission system 600 may include the data processing apparatus 400 described with reference to Fig. 4 (and additional aspects thereof), and the data processing apparatus 500 described with reference to Fig. 5 (and additional aspects thereof). Thus, the data processing apparatus 400 described with reference to Fig. 4 (and additional aspects thereof) and the data processing apparatus 500 described with reference to Fig. 5 (and additional aspects thereof) may be mapped to the data transmission system 600 described with reference to Fig. 6, which will not be repeated here.

The following describes one or more exemplary aspects described above with reference to Fig. 2 to Fig. 6 in conjunction with an exemplary application scenario. It may be understood that the exemplary application scenario described below is only an example but not a limitation, and is intended to implement one or more aspects described above with reference to Fig. 2 to Fig. 6 in a specific application scenario, or only describe an example of implementing one or more aspects described above with reference to Fig. 2 to Fig. 6. Various aspects described below in conjunction with the exemplary application scenario may be combined with one or more aspects described above with reference to Fig. 2 to Fig. 6.

The exemplary application scenario describes a low-latency RS (272, 258) multi-way interleaved error correction structure, but the embodiments are not limited thereto. In other aspects, the multi-way interleaved error correction structures involving other algorithms, or other multi-way interleaved error correction structures of the same algorithm may be provided.

Exemplarily, the error correction structure mainly includes the following modules and processes: an RS encoder, a decoder, a syndrome calculation module, a key equation calculation module, a Chien search module, a multi-way interleaved module and process, and a decoding and error correction process. The above modules and processes will be explained in detail below.

The RS encoder is described below. For example, the RS encoder may implement one or more aspects of the encoding operation described above.

The encoding principle of RS codes is to increase certain redundancy according to certain encoding rules, so that originally irrelevant data becomes relevant. For example, in this exemplary application scenario, an encoder based on division may be used.

The exemplary process of encoding based on division is divided into the following 3 steps:
(1) Pre-multiply an information polynomial *m*(*x*) by *x*^{*n*-*k*}, that is, shift right by *n* -*k* bits to obtain *x*^{*n*-}*^{k}m*(*x*);
(2) Divide *x*^{*n*-}*^{k}m*(*x*) by a generator polynomial *g*(*x*) to obtain a remainder *r*(*x*), where *g*(*x*) determines a unique *RS*(*n*, *k*) code;
(3) According to *x*^{*n*-}*^{k}m*(*x*) + *r*(*x*) = *c*(*x*) , an encoded codeword polynomial is obtained.

Of course, the embodiments are not limited thereto. For example, an encoder using matrix multiplication or other algorithms may be used.

The decoding and error correction process is described below. For example, the decoding and error correction process may implement one or more aspects of the decoding and error correction operations described above.

The decoding principle is to utilize the data correlation generated by redundancy to correct errors occurring in the channel, and recover the transmitted code sequence.

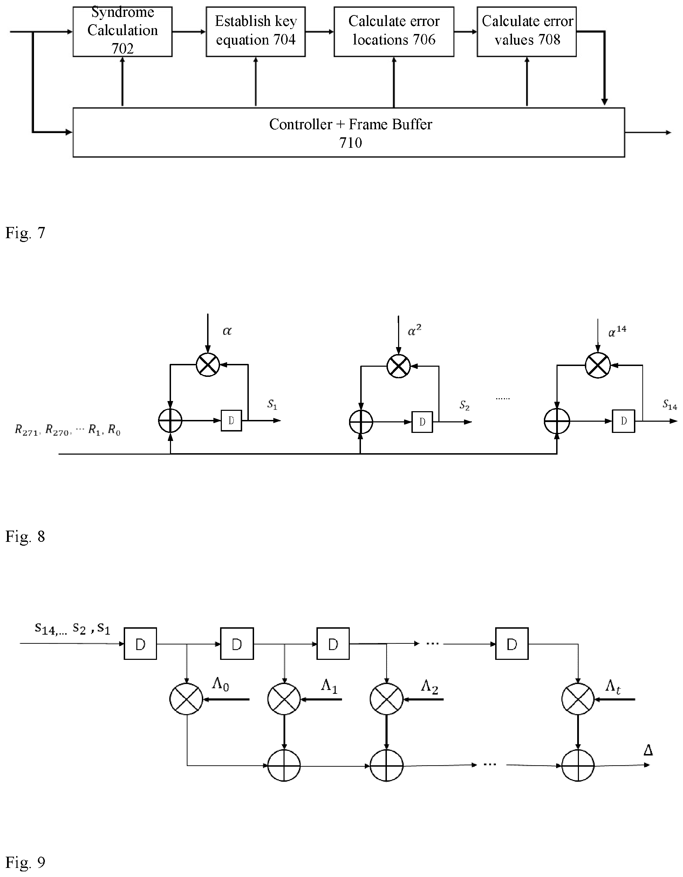

Fig. 7 shows a schematic diagram of a decoding and error correction process according to at least one embodiment of the present disclosure.

Referring to Fig. 7, an exemplary decoding and error correction process is divided into the following 5 steps:
(1) In block 702, syndrome calculation is performed, for example, to obtain a syndrome *Sⱼ* from a received polynomial;
(2) In block 704, a key equation is established, for example, according to the syndrome *Sⱼ,* the key equation is solved using, for example, BM algorithm, to obtain an error polynomial and an error value polynomial;
(3) In block 706, error locations are calculated, for example, all possible error locations are substituted into the key equation, and the roots of the error polynomial are solved using, for example, Chien search algorithm, to obtain the error locations;
(4) In block 708, error values are calculated; for example, Forney algorithm is used to calculate the error values;
(5) Subsequently, error correction may be performed based on the error locations and error values, and the error correction is completed.

In Fig. 7, a controller + frame buffer 710 may be used to control the calculation of corresponding data in each block of blocks 702-708, and buffer data required for corresponding calculations and/or calculation results.

Of course, the embodiments are not limited thereto. For example, other algorithms may be used to implement the above decoding and error correction process, or other decoding and error correction processes may be used.

More detailed exemplary aspects of the decoding and error correction process described with reference to Fig. 7 are described below.

First, the syndrome calculation is described.

The syndrome of the RS (272, 258) code may be set as formula (1): $S \left(x\right) = {\sum }_{j = 1}^{2 t} {S}_{j} {x}^{j - 1} = {S}_{1} + {S}_{2} x + {S}_{3} {x}^{2} + ⋯ {S}_{14} {x}^{13}$
where ${S}_{j} = {\sum }_{i = 0}^{n - 1} {R}_{i} ⋅ {a}^{i \left({b}_{0}+j-1\right)} = {\sum }_{i = 0}^{271} {R}_{i} ⋅ {a}^{ij} , j = 1 , 2 ,⋯ 2 t , t = \frac{n - k}{2}$.

In practice, Horner algorithm may be used to calculate *Sⱼ*, as shown in formula (2): ${S}_{j} = \left(\left(⋯\left({R}_{n - 1}{a}^{{b}_{+ j - j}}+{R}_{n - 2}\right){a}^{{b}_{+} + j - 1}+{R}_{n - 3}\right){a}^{{b}_{+ j - 1}}+⋯{R}_{1}\right) {a}^{{b}_{0 + j - 1}} + {R}_{0}$

Substituting n = 272 and b = 1 into formula (2), then: $\begin{matrix}{S}_{1} = \left(\left(⋯\left({R}_{271}α+{R}_{270}\right)α+{R}_{269}\right)α+⋯{R}_{1}\right) α + {R}_{0} \\ {S}_{2} = \left(\left(⋯\left({R}_{271}{α}^{2}+{R}_{270}\right){α}^{2}+{R}_{269}\right){α}^{2}+⋯{R}_{1}\right) {α}^{2} + {R}_{0} \\ ⋯ \\ {S}_{14} = \left(\left(⋯\left({R}_{271}{α}^{14}+{R}_{270}\right){α}^{14}+{R}_{269}\right){α}^{14}+⋯{R}_{1}\right) {α}^{14} + {R}_{0}\end{matrix}$

For example, in engineering design, a pipelined structure may be used to implement syndrome calculation in hardware.

Fig. 8 shows a block diagram of syndrome calculation according to at least one embodiment of the present disclosure.

Referring to Fig. 8, "⊗" represents finite field multiplication, and "⊕" represents finite field addition. During syndrome calculation, a module is first initialized, and then *R*₁, *R*₂, ··· , *R*₂₇₁ are sequentially shifted into a shift register. 14 syndromes may be calculated after 272 clock cycles. If all syndrome coefficients are 0, it indicates that all received codewords are correct, and the number of errors is 0; otherwise, the number of errors is greater than 0.

Next, a key equation is described.

After 14 syndromes are solved, the error location polynomial may be solved using, for example, an improved BM algorithm. Because the earliest proposed BM algorithm requires finite field element inversion operation, so the algorithm requires finite field division operation in each iteration, where the finite field element inversion operation/finite field division operation is very complex, and its complexity makes such algorithm unsuitable for high-speed implementation. Therefore, an exemplary improved algorithm process is as follows:
(1) Initialization: Λ⁽⁰⁾*(x)* = 1, *T*⁽⁰⁾(*x*) = 1, *L*⁽⁰⁾(*x*) = 0, *γ*⁽⁰⁾(*x*) = 1, *k* = 0;
(2) The following steps are cyclically iterated from formula (4) to formula (7) until *k* = 2t - 1, and then the cycle ends; ${Δ}^{\left(k-1\right)} = {\sum }_{j = 0}^{{L}^{\left(k\right)}} {Λ}_{j}^{\left(k\right)} {S}_{k - j}$ ${Λ}^{\left(k-1\right)} \left(x\right) = {γ}^{\left(k\right)} {Λ}^{\left(k\right)} \left(x\right) - {Δ}^{\left(k-1\right)} {T}^{\left(k\right)} \left(x\right) x$ When Δ^{(*k*-1)} = 0 or 2*L*^{(*k*)} > *k,* ${T}^{\left(k-1\right)} \left(x\right) = {xT}^{\left(k\right)} \left(x\right) , {L}^{\left(k+1\right)} = {L}^{\left(k\right)} , {γ}^{\left(k+1\right)} = {γ}^{\left(k\right)}$ otherwise, when Δ^{(*k*-1)} ≠ 0 or 2*L*^{(*k*)} ≤ *k,* $\begin{matrix}{T}^{\left(k-1\right)} \left(x\right) = {Λ}^{\left(k\right)} \left(x\right) , {L}^{\left(k-1\right)} = k + 1 - {L}^{\left(k\right)} , {γ}^{\left(k+1\right)} = {Δ}^{\left(k-1\right)} \\ k = k + 1 ;\end{matrix}$ where Λ^{(*k*-1)}*(x)* is the error location polynomial.

In formula (4), Δ is the convolution sum operation of A(x) and *S*(*x*). To implement pipelined processing, for example, finite impulse response (FIR) filter technology may be used to implement pipelined processing, as shown in Fig. 9.

Fig. 9 shows a block diagram of a key equation according to at least one embodiment of the present disclosure.

Referring to Fig. 9, during initialization, all registers (D) are set to 0. Then, as the rising edge of each clock arrives, *S*₁, *S*₂, ··· , *S*₁₄ are sequentially shifted into a shift register, and finally, each coefficient of the error location polynomial A(x) may be obtained.

Then, Chien search is described.

After an error value polynomial is obtained from the key equation, to simplify the calculation, Chien search method is used to find the roots of the error value polynomial. The exemplary method is as follows.

Let: $R \left(x\right) = {r}_{271} {x}^{271} + {r}_{270} {x}^{270} + ⋯ + {r}_{1} x + {r}_{0}$ to check whether the first bit *r*_{*n*-1} is in error, it is necessary to determine whether *α*^{*n*-1} is an error location number, that is, to check whether *α*^{-(*n*-1)} is a root of *σ*(*x*). If *α*^{-(*n*-1)} = *α* is a root of *σ*(*x*), then: $σ \left({α}^{- \left(n-1\right)}\right) = σ \left(x\right) = 1 + {σ}_{1} α + {σ}_{2} α + ⋯ + {σ}_{t} {α}^{t} = 0$ or *σ*₁*α + σ*₂*α* + ··· *+ σₜα^{t}* = -1.

Thus, it may be judged that an error occurs at the *α*^{*n*-1} bit. By analogy, it may be derived that:
If *σ*₁(*α*) + *σ*₂(*α*) *+* ··· + *σₜ*(*α*)*^{t}* = -1, then there is an error at the *α*²⁷¹ position;
If *σ*₁(*α*²) + *σ*₂(*α*²) + ··· + *σₜ*(*α*²)*^{t}* = -1, then there is an error at the *α*²⁷⁰ position; ...
If *σ*₁*(αⁱ*) + *σ*₂(*αⁱ*) + ··· + *σₜ*(*αⁱ*)*^{t}* = -1, then there is an error at the *α*^{271-*i*} position;
If *σ*₁(*αⁿ*) + *σ*₂*(αⁿ*) + ··· + *σₜ*(*αⁿ*)*^{t}* = -1, then there is an error at the *α*⁰ position;
where the *αⁿ⁻ⁱ* bit is also the *xⁿ⁻ⁱ* bit.

Thus, by checking each *αⁿ⁻ⁱ*(*i* = 1,2, ··· , *n*) in turn, the roots of the error value polynomial are obtained. According to, for example, Forney algorithm, the error value when *δ*(*aᵢ*) = 0 is: ${e}_{i} = \frac{w \left({α}^{n - i}\right)}{{α}^{n - i} σ ′ \left({α}^{n - i}\right)} .$

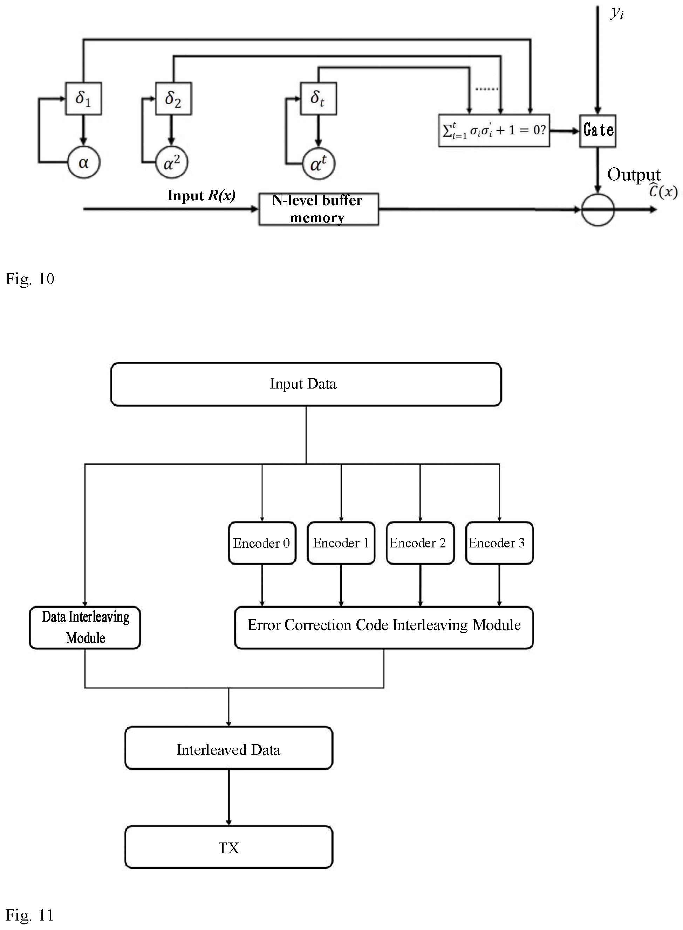

Fig. 10 shows a schematic diagram of a Chien search circuit according to at least one embodiment of the present disclosure. In the example application scenario, the Chien search circuit may be used to implement error location search and error correction, and its exemplary process is as follows.
(1) There are t registers store *σ*₀, *σ*₁, *σ*₂, ... ... *σₜ*. If the actual number of errors of data output from the register system channel v<t, then *σ*_{*v*+1} = *σ*_{*v*+2} = ...= *σₜ* = 0.
(2) Before *r*_{*n*-1} is about to be read from the buffer memory, t multipliers perform multiplication under the control of shift pulses, and store the following values in the registers: *σ*₀*α*, *σ*₂*a*², ... , *σₜa^{t}*, these values are accumulated, and if the value is -1, then controlling a gate to be opened, and the error value is subtracted from *r*_{*n*-1} output by the buffer, and *C*_{*n*-1} completes error correction for *r*_{*n*-1}.
(3) After the decoding of *r*_{*n*-1} is completed, multiplication is performed again. At this time, *σ*₁*a*², *σ*₂(*a*²)², *σₜ*(*a^{t}*)² are stored in register *σ*, and addition operations and checking are performed to correct *r*_{*n*-2}. The remaining symbols are corrected in the same way as (2).

It may be understood that the above describes an exemplary embodiment of the decoding and error correction process. However, the embodiments are not limited thereto. For example, the decoding and error correction process may be implemented through matrix operations or other algorithms.

An interleaved error correction structure is described below. For example, one or more exemplary aspects of the data processing method described above may be implemented in the interleaved error correction structure.

The interleaved error correction structure is, for example, an encoding technology used to correct data errors and solve delays. By dividing original data into several independent data streams, and alternately arranging these data streams into a new data stream, the interleaved error correction structure enhances data reliability. In this error correction structure, each data stream may correct and detect errors using error correction coding.

Fig. 11 shows a schematic diagram of a four-way interleaved structure according to at least one embodiment of the present disclosure. For example, the four-way interleaved structure described with reference to Fig. 11, may be used for one or more exemplary aspects of a data transmitting end or the data processing apparatus 400.

Referring to Fig. 11, input data may be divided into 4 pieces of sub-data. The input data here may correspond to the original data described above.

On the one hand, the 4 pieces of sub-data may be transmitted to a data interleaving module, to perform interleaving operation on these sub-data. On the other hand, the 4 pieces of sub-data may be input to 4 encoders respectively for independent encoding, to generate corresponding error correction codes. For example, the first sub-data of the 4 pieces of sub-data may be input to encoder 0 for encoding, to generate an error correction code for the first sub-data, the second sub-data of the 4 pieces of sub-data may be input to encoder 1 for encoding, to generate an error correction code for the second sub-data, the third sub-data of the 4 pieces of sub-data may be input to encoder 2 for encoding, to generate an error correction code for the third sub-data, and the fourth sub-data of the 4 pieces of sub-data may be input to encoder 3 for encoding, to generate an error correction code for the fourth sub-data.

After obtaining respective error correction codes for the 4 pieces of sub-data, these error correction codes may be transmitted to an ECC interleaving module, to perform interleaving operation on these error correction codes.

In the above embodiment, 4 independent ECC words, that is, 4 pieces of sub-data and their corresponding error correction codes, may be obtained, and interleaving operation may be performed on the sub-data and error correction codes. Of course, the embodiments are not limited thereto. In some embodiments, 4 independent ECC words may also be directly obtained through encoders, and interleaving operation may be performed on the sub-data and error correction codes in the 4 independent ECC words.

After the above interleaving operation, interleaved data may be obtained. Subsequently, the interleaved data may be transmitted (TX) via a channel or link.

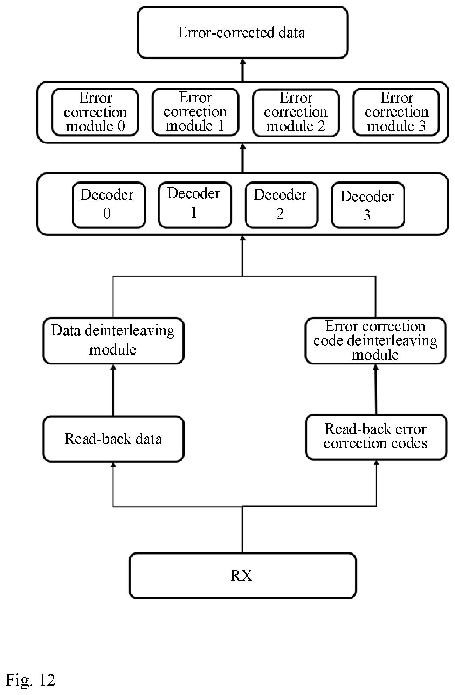

Fig. 12 shows a schematic diagram of a four-way deinterleaved structure according to at least one embodiment of the present disclosure. For example, the four-way deinterleaved structure described with reference to Fig. 12 may be used for one or more exemplary aspects of a data receiving end or the data processing apparatus 500.

Referring to Fig. 12, interleaved data may be received (RX) via, for example, a channel or link, thereby obtaining read-back data and read-back error correction codes. The interleaved data here may be the interleaved data generated by various aspects described with reference to Fig. 11.

The read-back data and read-back error correction codes may pass through a data deinterleaving module and an error correction code deinterleaving module respectively, to obtain 4 independent read-back error correction codewords (for example, corresponding to the 4 independent ECC words in Fig. 11).

Subsequently, the 4 independent read-back error correction codewords may be transmitted to a decoder and an error correction module for decoding and error correction operations, to obtain corrected data. For example, the 4 independent read-back error correction codewords may pass through their own decoders and error correction modules respectively, for decoding and error correction operations. Exemplarily, the first read-back error correction codeword of the 4 independent read-back error correction codewords may pass through decoder 0 and error correction module 0 for decoding and error correction operations; the second read-back error correction codeword of the 4 independent read-back error correction codewords may pass through decoder 1 and error correction module 1 for decoding and error correction operations; the third read-back error correction codeword of the 4 independent read-back error correction codewords may pass through decoder 2 and error correction module 2 for decoding and error correction operations; and the fourth read-back error correction codeword of the 4 independent read-back error correction codewords may pass through decoder 3 and error correction module 3 for decoding and error correction operations.

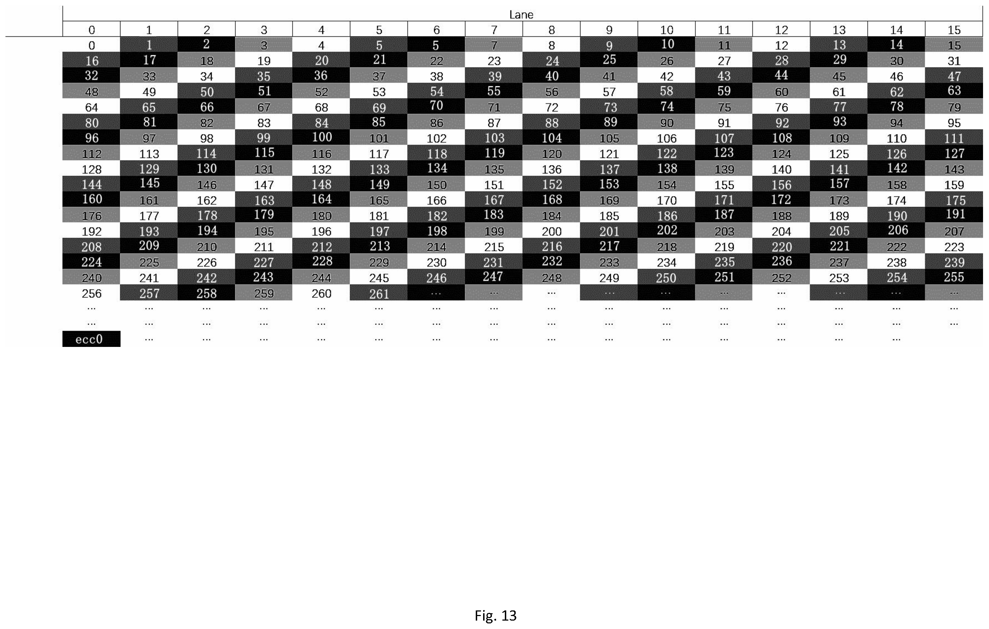

Fig. 13 shows a structural diagram of four-way interleaved data according to at least one embodiment of the present disclosure. The four-way interleaved data structure described with reference to Fig. 13 may be, for example, a four-way interleaved data structure applicable to RS (272, 258) algorithm. Of course, the embodiments are not limited thereto. For example, the four-way interleaved data structure may also be used for other algorithms. For another example, for different algorithms, interleaved data structures with other numbers of ways may also be used.

Referring to Fig. 13, 4 independent error correction codewords may be transmitted through 16 data lanes (i.e., lanes in the figure). Of course, other numbers of data lanes may be used according to different requirements and/or different data transmission protocols.

Referring to Fig. 13, consecutive 4 symbols on each data lane may belong to, for example, different FEC ECC words. In this case, this may ensure that continuous errors on the same data lane may be dispersed into different FECs. Exemplarily, each small block in Fig. 13 represents a 10-bit symbol, and the data in the 10-bit symbol all belong to 10-bit data continuously transmitted on the same data lane. In Fig. 13, symbols with the same gray scale belong to the same FEC ECC word. For example, on data lane 0, symbols 0, 16, 32, and 48 from top to bottom are from the first ECC word, the second ECC word, the third ECC word and the fourth ECC word of 4 different ECC words respectively; similarly, symbols 64, 80, 96, and 112 may be from the first ECC word, the second ECC word, the third ECC word and the fourth ECC word of 4 different ECC words respectively, and so on. Other data lanes may have the same or similar data structure as data lane 0. In this way, symbols of different ECC words are arranged in an interleaved manner.

For example, with reference to Fig. 13, assuming that a continuous error starts to propagate from the symbol labeled 18 in Fig. 13, passing through symbols 34, 50, and 66, then only 1 symbol error is introduced into each ECC word, which may be easily corrected. For example, in the case of adopting RS (272, 258) algorithm, the four-way interleaved error correction structure may correct any 7 such continuous errors, thus greatly improving the bandwidth efficiency of the system.

In an additional aspect, referring to Fig. 13, corresponding symbols on adjacent data lanes of a plurality of data lanes belong to different error correction codewords of the 4 independent error correction codewords. For example, the symbol 0 on the data lane 0 and the symbol 1 on the data lane 1 belong to different error correction codewords of the 4 independent error correction codewords, and the symbol 16 on the data lane 0 and the symbol 17 on the data lane 1 belong to different error correction codewords of the 4 independent error correction codewords.

Fig. 13 shows the case where consecutive 4 symbols on each data lane of a plurality of data lanes belong to different ECC words, and corresponding symbols on adjacent data lanes of a plurality of data lanes belong to different error correction codewords of 4 independent error correction codewords. For example, referring to Fig. 13, symbols from top to bottom on each data lane (i.e., corresponding to each column) belong to the first ECC word, the second ECC word, the third ECC word and the fourth ECC word of 4 different ECC words in turn, and so on; corresponding symbols on adjacent data lanes (i.e., corresponding to each column) belong to the first ECC word, the second ECC word, the third ECC word and the fourth ECC word of 4 different ECC words in turn. Of course, the embodiments are not limited thereto, and other interleaved data structures may exist.

The example application scenario may provide a multi-way interleaved encoding structure. For example, a plurality of FECs perform interleaved encoding in the multi-way interleaved encoding structure, ensuring the interleaved arrangement of symbols of different FECs on the same data lane and adjacent data lanes, thereby effectively dealing with burst errors on the same data lane, and crosstalk on adjacent data lanes, where burst errors on a channel or a link are spread out in time, and are converted into independent random errors, which gives full play to the role of error correction codes.

The exemplary application scenario may provide more space for link coefficient training. For example, through the error correction mechanism of the interleaving and RS encoding, both random errors and burst errors may be dealt with. Even if the equalization coefficient of the link does not reach the optimal, the reliability and bandwidth efficiency of system data transmission will not decrease significantly.

The exemplary application scenario may make the equalization strategy, system packet loss rate, delay, and area be in an overall optimal state, thereby improving the overall performance of the system.

For the exemplary algorithm, the exemplary application scenario may provide, for example, a RS (272, 258) four-way interleaved error correction structure, which has the advantages of low latency, almost no bandwidth loss, small ECC words, suitability for FEC design with joint link equalization, and high code rate.

For example, in terms of low latency, the complexity of encoding, decoding and error correction may be reduced, and the number of iterations of a single FEC is small, which has the characteristic of low latency compared with the traditional RS (544, 514) algorithm.

For another example, in terms of almost no bandwidth loss, a typical scenario of burst errors is that there are a plurality of random errors in an ECC word, and random errors cause DFE error decision, resulting in each symbol with a random error having a high probability of causing the next symbol to also have an error (the probability of error propagating to the third symbol is much lower). Such scenario of consecutive two error symbols may be well handled by the multi-way interleaved RS (272, 258). Both a single RS (544, 514) and a two-way RS (272, 258) may correct any 7 errors with consecutive two error symbols. The multi-way interleaving may correct errors in transmission more effectively, improving the reliability of data transmission.

For another example, in terms of small ECC words, compared with the existing RS (544, 514), by adopting RS (272, 258) encoding, the length of error correction codes is reduced, the complexity of the error correction module is reduced, and the frequency may be increased.

For another example, in terms of FEC designs suitable for joint link equalization, an interleaved FEC is designed for scenarios with joint link equalization, where BER is relatively good but the error propagation coefficient "burst" is large. Furthermore, the actual error correction capability is improved, delay is reduced, and area is optimized, achieving the goal of overall optimization.

For another example, in terms of high code rate, compared with the commonly used RS (544, 514), the code rate is higher. RS (544, 514) may have 5140 bits of data in every 5440 bits, while the multi-way interleaved RS (272, 258) may have 5160 bits of data in every 5440 bits.

In additional or alternative aspects of the above exemplary application scenario, the shown error correction structure may be used for various high-speed links, and also supports an end-to-end overall solution. For example, future links may not only be based on electrical signals, but also be based on optical signals. Electrical signals may be first transmitted to an optical transmission module through a short-distance high-speed link, the optical module converts the signals and transmits them to a long-distance optical receiving module through an optical fiber, and then the optical receiving module converts the optical signals into electrical signals and transmits them to the final receiving end of the link. Therefore, the error correction structure in the above exemplary application scenario may not only correct random errors, but also deal with continuous errors well, which may be applied to the above end-to-end overall solution, for example, encoding at an electrical transmitting end and decoding at an electrical receiving end, to provide end-to-end protection, thereby saving the encoding and decoding time of the optical module, and improving the efficiency and reliability of the entire system.

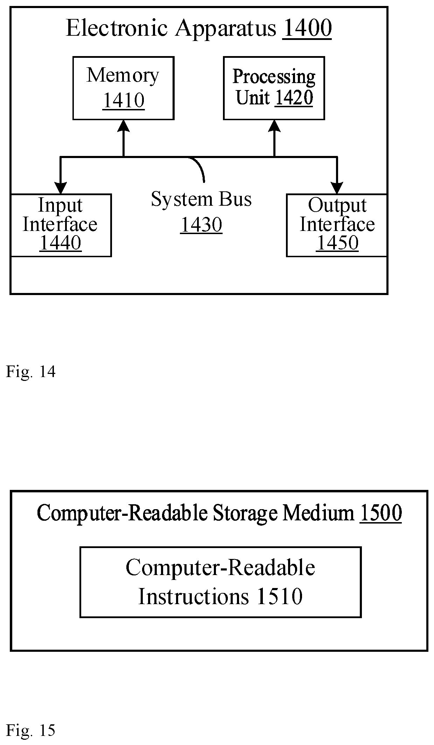

Fig. 14 shows a schematic diagram of an electronic apparatus 1400 according to at least one embodiment of the present disclosure.

As shown in Fig. 14, the electronic apparatus 1400 includes at least one processing unit 1420 and at least one memory 1410. The memory 1410 stores computer-readable instructions, and is communicatively connected to the processing unit 1420. The processing unit 1420 executes the computer-readable instructions stored in the memory 1410, to implement the data processing method and additional aspects thereof according to at least one embodiment of the present disclosure.

For example, the memory 1410 and the processing unit 1420 may communicate with each other directly or indirectly. For example, in some examples, as shown in Fig. 14, the electronic apparatus 1400 may further include a system bus 1430, and the memory 1410 and the processing unit 1420 may communicate with each other through the system bus 1430. For example, the processing unit 1420 may access the memory 1410 through the system bus 1430. For example, in other examples, components such as the memory 1410 and the processing unit 1420 may communicate through a network on chip (NOC) connection.

For example, the processing unit 1420 may control other components in the electronic apparatus 1400, to perform desired functions. The processing unit 1420 may be a central processing unit (CPU), a tensor processing unit (TPU), a network processor (NP), a graphics processing unit (GPU), or other devices with data processing capabilities and/or program execution capabilities, and may also be a digital signal processor (DSP), an application-specific integrated circuit (ASIC), a field programmable gate array (FPGA), or other programmable logic devices, discrete gate, transistor logic devices or discrete hardware components, etc.

For example, the memory 1410 may include any combination of one or more computer program products; and the computer program products may include various forms of computer-readable storage media, for example, a volatile memory and/or a non-volatile memory. The volatile memory may include, for example, a random access memory (RAM) and/or a cache, or the like. The non-volatile memory may include, for example, a read only memory (ROM), a hard disk, an erasable programmable read only memory (EPROM), a portable compact disk read only memory (CD-ROM), a USB memory, a flash memory, or the like.

For example, one or more computer-readable instructions may be stored in the memory 1410, and the processing unit 1420 may run the computer-readable instructions to implement various functions. Various application programs and various data, such as instruction processing codes and various data used and/or generated by the application programs, may also be stored in the computer-readable storage medium.

For example, some computer instructions stored in the memory 1410, upon executed by the processing unit 1420, may execute one or more steps in the data processing method described above.

For example, as shown in Fig. 14, the electronic apparatus 1400 may further include an input interface 1440 that allows external devices to communicate with the electronic apparatus 1400. For example, the input interface 1440 may be used to receive instructions from an external computer device, a user, etc. The electronic apparatus 1400 may further include an output interface 1450 that allows the electronic apparatus 1400 to interconnect with one or more external devices. For example, the electronic apparatus 1400 may pass through the output interface 1450, etc.

It should be noted that the electronic apparatus 1400 according to at least one embodiment of the present disclosure is exemplary and not restrictive. According to actual application requirements, the electronic apparatus 1400 may further include other conventional components or structures. For example, to implement the necessary functions of an electronic apparatus, those skilled in the art may set other conventional components or structures according to specific application scenarios, which are not limited by the embodiments of the present disclosure.

At least one embodiment of the present disclosure further provides a computer-readable storage medium. Fig. 15 shows a schematic diagram of the computer-readable storage medium 1500 according to at least one embodiment of the present disclosure.

For example, as shown in Fig. 15, the computer-readable storage medium 1500 stores computer-readable instructions 1510, and the computer-readable instructions 1510, when executed by a computer (includes a processor), may execute one or more steps of the method for processing data according to the at least one embodiment of the present disclosure and additional aspects thereof.

For example, one or more computer-readable instructions may be stored on the computer-readable storage medium 1500. Some computer-readable instructions stored on the computer-readable storage medium 1500 may be, for example, instructions for implementing one or more steps in the data processing method described above.

For example, a computer-readable storage medium may include a storage component of a tablet computer, a hard disk of a personal computer, a random access memory (RAM), read-only memory (ROM), an erasable programmable read-only memory (EPROM), a compact disc read-only memory (CD-ROM), a flash memory, or any combination of the above computer-readable storage media, or other applicable storage media. For example, the computer-readable storage medium 1500 may include the memory 1410 in the electronic apparatus 1400 described above.

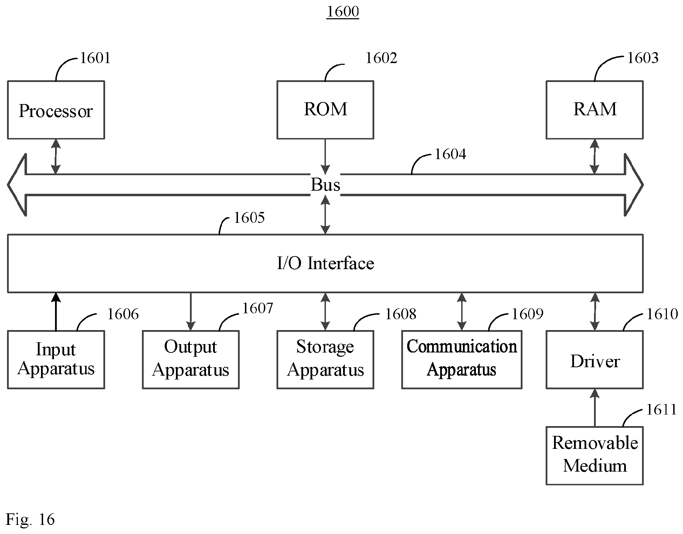

At least some embodiments of the present disclosure further provide an electronic apparatus. Fig. 16 shows a schematic diagram of another electronic apparatus 1600 according to at least one embodiment of the present disclosure.

An electronic apparatus according to at least one embodiment of the present disclosure may be implemented as, but not limited to, mobile terminals such as a mobile phone, a notebook computer, a digital broadcasting receiver, a personal digital assistant (PDA), a portable Android device (PAD), a portable media player (PMP), a vehicle-mounted terminal (e.g., a vehicle-mounted navigation terminal) or the like, and fixed terminals such as a digital TV, a desktop computer, or the like..

The electronic apparatus 1600 shown in Fig. 16 is merely an example, and should not pose any limitation to the functions and the range of use of the embodiments of the present disclosure.

For example, as shown in Fig. 16, in some examples, the electronic apparatus 1600 includes a processor 1601, the processor may include the processor of any of the above embodiments (e.g., an SMT processor), which can perform various suitable actions and processing according to a program stored in a read-only memory (ROM) 1602 or a program loaded from a storage apparatus 1608 into a random-access memory (RAM) 1603. The RAM 1603 further stores various programs and data required for operations of the computer operation system. The processor 1601, the ROM 220, and the RAM 230 are interconnected by means of the bus 1604. An input/output (I/O) interface 1605 is also connected to the bus 1604.

For example, the following components may be connected to the I/O interface 1605: an input apparatus 1606 including, for example, a touch screen, a touch pad, a keyboard, a mouse, a camera, a microphone, an accelerometer, a gyroscope, etc.; an output apparatus 1607 including, for example, a liquid crystal display (LCD), a loudspeaker, a vibrator, etc.; a storage apparatus 1608 including, for example, a magnetic tape, a hard disk, etc.; and a communication apparatus 1609 which may include, for example, a network interface card such as a LAN card, a modem, etc. The communication apparatus 1609 may allow the electronic apparatus 1600 to perform wireless or wired communication with other devices to exchange data, and perform communication processing via a network such as the Internet. A driver 1610 is also connected to the I/O interface 1605 as needed. The removable medium 1611, such as a magnetic disk, an optical disk, a magneto-optical disk, a semiconductor memory, etc., is installed on the driver 1610 as needed, so that a computer program read therefrom is installed into the storage apparatus 1608 as needed. Although Fig. 16 shows an electronic apparatus 1600 including various apparatuses, it should be understood that it is not required to implement or include all the shown apparatuses. It may alternatively implement or include more or fewer apparatuses.

For example, the electronic apparatus 1600 may further include a peripheral interface (not shown in the figure), etc. The peripheral interface may be interfaces of various types, for example, a USB interface, a lighting interface, etc. The communication apparatus 1609 may communicate with a network and other devices through wireless communication; the network is, for example, the Internet, an intranet and/or a wireless network such as a cellular telephone network, a wireless local area network (LAN) and/or a metropolitan area network (MAN). Wireless communication may adopt any one of a variety of communication standards, protocols and technologies, including but not limited to global system for mobile communication (GSM), enhanced data GSM environment (EDGE), wideband code division a plurality of access (W-CDMA), code division a plurality of access (CDMA), time division a plurality of access (TDMA), Bluetooth, Wi-Fi (e.g., based on IEEE 802. 11a, IEEE 802. 11b, IEEE 802. 11g and/or IEEE 802. 11n standards), voice over Internet protocol (VoIP), Wi-MAX, protocols for e-mail, instant messaging and/or short message service (SMS), or any other suitable communication protocol.

For the present disclosure, in addition to the aforementioned exemplary descriptions, the following statements should be noted:
(1) The drawings involve only the structure(s) in connection with the embodiment(s) of the present disclosure, and other structure(s) can be referred to common design(s).
(2) In case of no conflict, features in one embodiment or in different embodiments can be combined to obtain new embodiments.

What have been described above are only exemplary embodiments of the present disclosure, and are not intended to limit the protection scope of the present disclosure, and the protection scope of the present disclosure is determined by the appended claims.

## Claims

1. A data processing method, comprising:
performing an encoding operation based on original data to generate N independent error correction codewords, wherein each error correction codeword of the N independent error correction codewords comprises a data code and a check code, and N is an integer and N ≥ 2;
interleaving data codes and check codes comprised in the N independent error correction codewords to obtain interleaved data; and
transmitting the interleaved data.

2. The data processing method according to claim 1, wherein the N independent error correction codewords are transmitted through a plurality of data lanes, and the interleaving the data codes and the check codes comprised in the N independent error correction codewords comprises:
alternately arranging the N independent error correction codewords into a new data stream, so that consecutive M symbols on each data lane of the plurality of data lanes belong to different error correction codewords of the N independent error correction codewords, respectively, wherein M is an integer and 2 ≤ M ≤ N.

3. The data processing method according to claim 2, wherein M = N.

4. The data processing method according to claim 2 or 3, further comprising:
alternately arranging the N independent error correction codewords into a new data stream, so that corresponding symbols on adjacent data lanes of the plurality of data lanes belong to different error correction codewords of the N independent error correction codewords.

5. The data processing method according to any one of claims 1 to 4, wherein the performing the encoding operation based on the original data to generate N independent error correction codewords comprises:
dividing the original data into N pieces of independent sub-data to serve as the data codes; and
independently performing the encoding operation on the N pieces of independent sub-data, to obtain error correction codes for each piece of sub-data of the N pieces of independent sub-data to serve as the check codes.

6. The data processing method according to any one of claims 1 to 5, wherein the dividing the original data into the N pieces of independent sub-data comprises:
randomly dividing the original data into the N pieces of independent sub-data.

7. The data processing method according to any one of claims 1 to 6, wherein N = 4.

8. The data processing method according to claim 7, wherein the encoding operation employs an RS (272, 258) algorithm.

9. The data processing method according to any one of claims 1 to 8, wherein the interleaved data is transmitted through a high-speed link, and the high-speed link supports the interleaved data to be transmitted in a form of at least one of an electrical signal and an optical signal.

10. A data processing method, comprising:
receiving interleaved data to obtain read-back data codes and read-back error correction codes, wherein the interleaved data is obtained by performing an encoding operation based on original data to generate N independent error correction codewords, and interleaving data codes and check codes comprised in the N independent error correction codewords, each error correction codeword of the N independent error correction codewords comprises a data code and a check code, and N is an integer and N ≥ 2;
deinterleaving the read-back data codes and the read-back error correction codes to obtain N independent read-back error correction codewords; and
performing decoding and error correction operations on the N independent read-back error correction codewords.

11. The data processing method according to claim 10, wherein the performing the decoding and error correction operations on the N independent read-back error correction codewords comprises:
independently performing the decoding and error correction operations on each read-back error correction codeword of the N independent read-back error correction codewords.

12. A data processing apparatus, comprising:
an error correction codeword generation unit, configured to perform an encoding operation based on original data to generate N independent error correction codewords, wherein each error correction codeword of the N independent error correction codewords comprises a data code and a check code, and N is an integer and N ≥ 2;
an interleaving unit, configured to interleave data codes and check codes comprised in the N independent error correction codewords to obtain interleaved data; and
a transmitting unit, configured to transmit the interleaved data to a data receiving end.

13. A data processing apparatus, comprising:
a receiving unit, configured to receive interleaved data to obtain read-back data codes and read-back error correction codes, wherein the interleaved data is obtained by performing an encoding operation on original data to generate N independent error correction codewords, and interleaving the data codes and check codes comprised in the N independent error correction codewords, each error correction codeword of the N independent error correction codewords comprises a data code and a check code, and N is an integer and N ≥ 2;
a deinterleaving unit, configured to deinterleave the read-back data codes and the read-back error correction codes to obtain N independent read-back error correction codewords; and
a decoding and error correction unit, configured to perform decoding and error correction operations on the N independent read-back error correction codewords.

14. A data transmission system, comprising:
the data processing apparatus according to claim 12; or
the data processing apparatus according to claim 13.

15. An electronic apparatus, comprising:
at least one processor; and
at least one memory has instructions stored thereon,
wherein the instructions, when executed by a processor, cause the processor to perform the data processing method according to any one of claims 1 to 11.

16. A computer-readable storage medium, storing computer-readable instructions,
wherein the computer-readable instructions, when executed by a processor, cause the processor to perform the data processing method according to any one of claims 1 to 11.
